# EUROPEAN PATENT APPLICATION

(11) **EP 0 828 248 A2**
(43) Date of publication of application: **11.03.1998**
(21) Application number: 97115283.0
(22) Date of filing: 03.09.1997
(51) Int. Cl.: G11B 20/18, H03M 13/00

(54) **Error correction method and error correction device**

(30) Priority: 04.09.1996 JP 253812/96
(71) Applicant: SONY CORPORATION, Tokyo (JP)
(72) Inventor: Inoue, Koji, Shinagawa-ku, Tokyo (JP); Shigenobu, Masahiro, Shinagawa-ku, Tokyo (JP)
(74) Representative: Melzer, Wolfgang, Dipl.-Ing.

(57) **Abstract**

The error correction result is held by the shift register (28), and the error correction processing result held in the shift register (28) is circulated successively, and thereby the subsequent error correction is performed with reference to this error correction result, enabling error correction processing using a general-purpose memory (14) during error correction processing using repeatedly product code type error correction code.

## Description

### BACKGROUND OF THE INVENTION

### Field of the Invention

This invention relates to an error correction method and an error correction device to be applied to optical disc devices and magnetic reproduction devices. In the present invention, for error correction processing using repeatedly product code type error correction codes, error correction processing is performed using a general-purpose memory by holding an eraser pointer in a register.

### Description of the Related Art

In a conventional optical disc device, error correction capability is improved by using repeatedly a product code type error correction code for error correction processing.

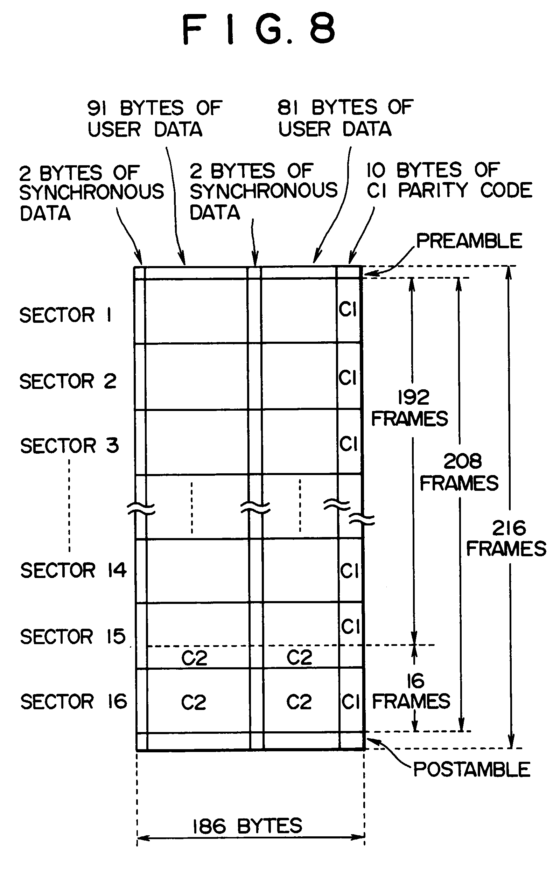

Fig. 8 is a diagram for illustrating an ECC block applied to such sort of optical disc, and in such optical disc device, error correction processing is performed for each ECC block as a unit. Herein the ECC block comprises frame data of 216 frames. In this ECC block of 216 frames, the head and tail 4 frames are assigned respectively to a preamble and postamble, and the residual 208 frames are assigned to, for example, successive 16 sectors (13 frames are assigned to each sector). In an ECC block, the head 192 frames out of 208 frames are assigned to user data, and the residual 16 frames are assigned to a C2 parity code.

Each frame comprises 186 byte data, and the head 2 bytes are assigned to synchronous data, similarly following 91 bytes to user data, successively, 2 bytes to synchronous data, 81 bytes to user data, and 10 bytes to C1 parity C1.

The optical disc device holds successive input-user data in a memory in the order of raster scanning of the table shown in Fig. 8 for recording. Further, the optical disc device scans this table in the vertical direction, and generates a C2 parity code of 16 bytes for each user data of 192 bytes on the one vertical column. Subsequently, the optical disc device scans the table in the horizontal direction and generates a C1 parity code of 10 bytes for each user data of 172 bytes on the one horizontal row and the C2 parity code. As described herein above, the optical disc device forms an ECC block of 1, outputs successively the table in the order of raster scanning to a modulation circuit, and records the user data, the C1 parity code, and the C2 parity code in an optical disc.

On the other hand for reproduction, the optical disc device stores reproduction data outputted from a decoding circuit in a memory in the order of raster scanning, thereby holds temporarily the reproduction data according to the arrangement of the table. Then, the optical disc device scans successively the table in the horizontal direction and performs error correction processing for each frame unit using the C1 parity code. When, the optical disc device sets an eraser pointer (referred to as C1 eraser pointer hereinafter) to the corresponding frame if it is difficult to correct an error by way of the C1 parity code, and records thereby the existence of a bit error in the corresponding frame.

Subsequently, the optical disc device scans the table in the vertical direction, and performs error correction processing using the C2 parity code. When, the optical disc device identifies the frame which includes the bit error and performs error correction processing with reference to C1 eraser pointer. Further, for a bit error which is detected but is difficult to be corrected by way of the above-mentioned method, an eraser pointer (C2 eraser pointer) is set. As described herein above, a frame in which a bit error is included is identified and then the location of the bit error is specified, and thereby error correction capability is improved.

The optical disc device performs error correction processing using the C2 parity code as described herein above, and subsequently performs again during error correction processing using the C1 parity code. When, the optical disc device specifies the location of the bit error with reference to C2 eraser pointer, and thereby performs error correction processing with application of improved error correction capability.

The optical disc device corrects a bit error of a reproduction data by repeating error correction processing using the C1 parity code and the C2 parity code with reference to C1 eraser pointer and C2 eraser pointer as described herein above as required, and thereafter outputs user data in order of raster scanning.

To do such operation, a conventional optical disc device structures this sort of the memory so that the memory can hold not only ECC block but also C1 eraser pointers and C2 eraser pointers. Further the memory is structured with 9 bit width in order to read C1 eraser pointers or C2 eraser pointers corresponding to user data of 1 byte (8 bits) using the address data of 1. C1 eraser pointers and C2 eraser pointers are set using commonly the residual area of 1 bit.

The optical disc device scans an ECC block in the order as described herein above to repeat error correction processing using the C1 parity code and the C2 parity code.

In a usual data processing device, a memory with 8 bit width is used. Therefore it is convenient to use a general-purpose memory with 8 bit width in such optical disc device.

The present invention has been accomplished in view of such subject, and proposes an error correction method and error correction device which are capable of performing error correction processing using a general-purpose memory.

### SUMMARY OF THE INVENTION

To solve such problem, in the error correction method and the error correction device of the present invention, an error correction result is held in a shift register, the error correction result held in the shift register is circulated successively, and the subsequent error correction processing is performed with reference to the error correction result.

A general-purpose memory can be made to hold a data group by holding the error correction result in the shift register. By circulating successively the error correction result held in the shift register, the error correction result corresponding to the data group held in the memory is inputted successively and error correction processing is performed even when the error correction result is held in the shift register.

### BRIEF DESCRIPTION OF THE DRAWINGS

Fig. 1 is a block diagram for illustrating an ECC circuit of an optical disc device in accordance with the present invention.

Fig. 2 is a block diagram for illustrating the optical disc shown in Fig. 1.

Fig. 3 is a time chart for describing operation of a memory in the optical disc device shown in Fig. 1.

Fig. 4 is a schematic diagram for describing error correction using the C1 parity code.

Fig. 5 is a schematic diagram for describing error correction using the C2 parity code.

Fig. 6 is a schematic diagram for describing an eraser pointer in error correction using the C2 parity code.

Fig. 7 is a schematic diagram for describing an eraser pointer in error correction using the C1 parity code.

Fig. 8 is a schematic diagram for describing an ECC block.

### DESCRIPTION OF THE PREFERRED EMBODIMENTS

Embodiments of the present invention will be described in detail hereinafter with reference to the drawings.

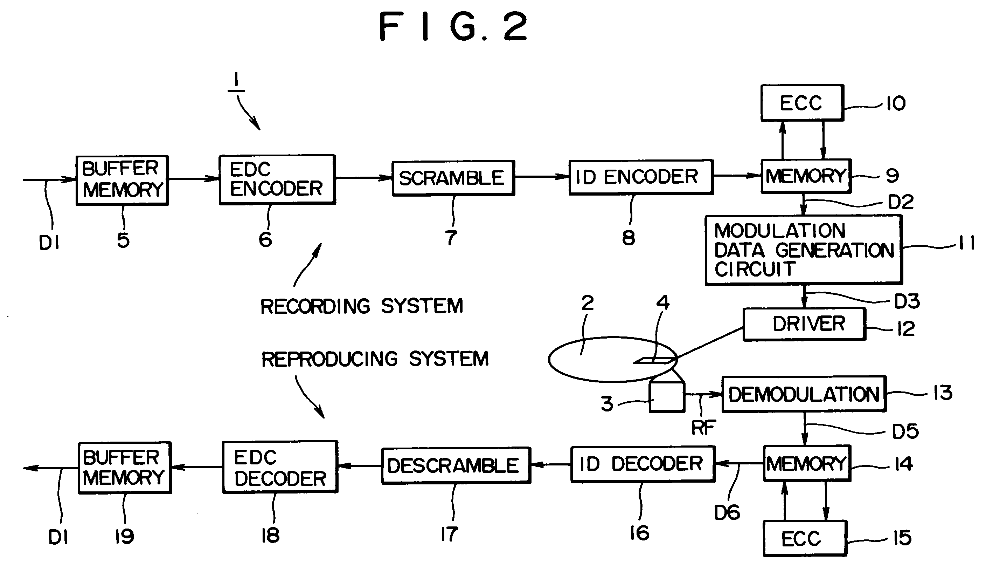

Fig. 2 is a block diagram for illustrating an optical disc device in accordance with an embodiment of the present invention. The optical-disc device 1 is applied as an external memory of a computer, records user data D1 in a magneto-optic disc 2, and reproduces and outputs the user data D1 recorded in the magneto-optic disc 2.

On the magneto-optic disc 2, track addresses and sector addresses are pre-formatted by pre-groove which forms guide grooves for the laser beam, a laser beam is irradiated from an optical pick-up 3 onto the magneto-optic disc 2 with rotation of a predetermined rotation speed, and the reflected beam is received by the optical pick-up 3. The magneto-optic disc 2 is structured so that a track address and sector address are detected with reference to a reproduction signal RF obtained by receiving the reflected beam. The magneto-optic disc 2 gives the rise of quantity of the laser beam intermittently with reference to the track address and sector address, a modulation coil 4 applies a modulation magnetic field, and thereby desired data are recorded thermomagnetically. The recorded data are reproduced by detecting change in plane of polarization of the reflected beam utilizing effectively magnetic Kerr effect.

In the optical disc device 1, a buffer memory 5 stores temporarily user data D1 and outputs it in predetermined block unit. An encoder 6 adds an error detection code to the user data D1 outputted from the buffer memory 5 and outputs it. A scramble circuit 7 interleaves and outputs the output data from the EDC encoder 6. An ID encoder 8 adds fixed data such as ID, synchronous data, and postamble to the output data from the scramble circuit 7 and outputs it.

A memory 9 holds the output data from the ID encoder 8 in compliance with address control of an address generator not shown in the drawing, and outputs the held data. An ECC circuit 10 generates an error correction the C1 parity code and the C2 parity code based on the data outputted from the memory 9, and stores the generated the C1 parity code and the C2 parity code in the memory 9. Then, the memory 9 outputs the C1 parity code and the C2 parity code added to the user data D1 as described herein above with the user data D1 in the order described in the description for Fig. 8.

A modulation data generation circuit 11 performs data processing of the output data D2 from the memory 9 and outputs a modulation data D3 which is suitable for recording in the magneto-optic disc 2. A driver 12 drives a modulation coil 4 based on the modulation data D3 correspondingly to quantity of laser beam which rises intermittently, and the optical disc device 1 records the user data D1 in the magneto-optic disc 2 by way of thermomagnetic recording method.

On the other hand for reproduction, in the optical disc device 1, a reproduction signal RF obtained from the optical pick-up 3 is inputted to a demodulation circuit 13. The demodulation circuit 13 generates a binary signal by converting the reproduction signal RF to the binary signal, and generates a reproduction clock based on the binary signal. The demodulation circuit 13 latches successively binary signals with reference to the reproduction clock, and generates thereby reproduction data. Further the demodulation circuit 13 performs data processing of the reproduction data correspondingly to data processing of the modulation data generation circuit 11, and generates a demodulation data D5 from the reproduction data to output.

A memory 14 holds the demodulation data D5 in compliance with address control of the address generator not shown in the drawing, and outputs the held demodulation data at a predetermined timing. An ECC circuit 15 performs error correction processing of the demodulation data outputted from the memory 14 using the C1 parity code and the C2 parity code, and stores it in the memory 14.

An ID decoder 16 detects the ID from the demodulation data D6 outputted from the memory 14 and outputs it selectively with reference to the detected ID. A descramble circuit 17 performs de-interleave processing of the output data and outputs it. An EDC decoder 18 performs error detection processing of the outputted data with reference to the error detection code added to the output data, and performs error correction processing when it is correctable. A buffer memory 19 holds the output data from the EDC decoder 18, and outputs it in response to request from the external apparatus.

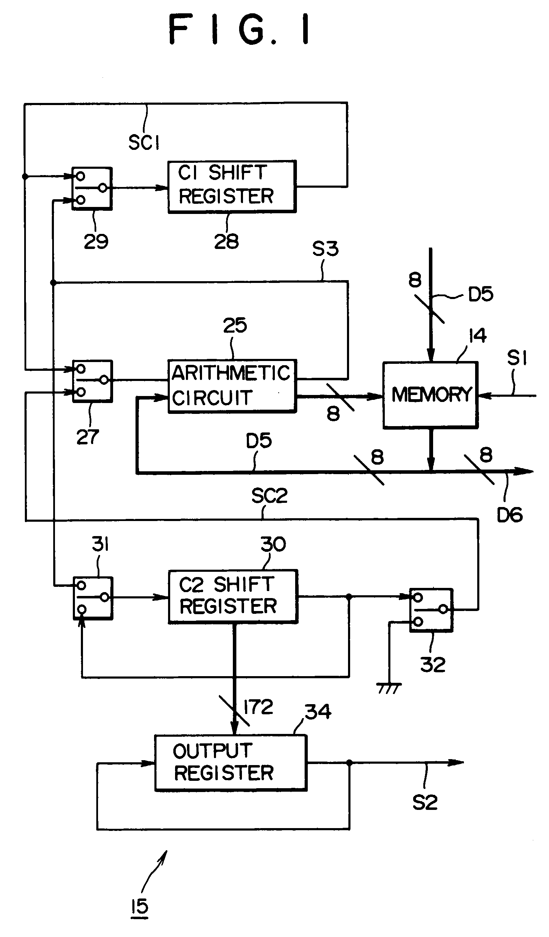

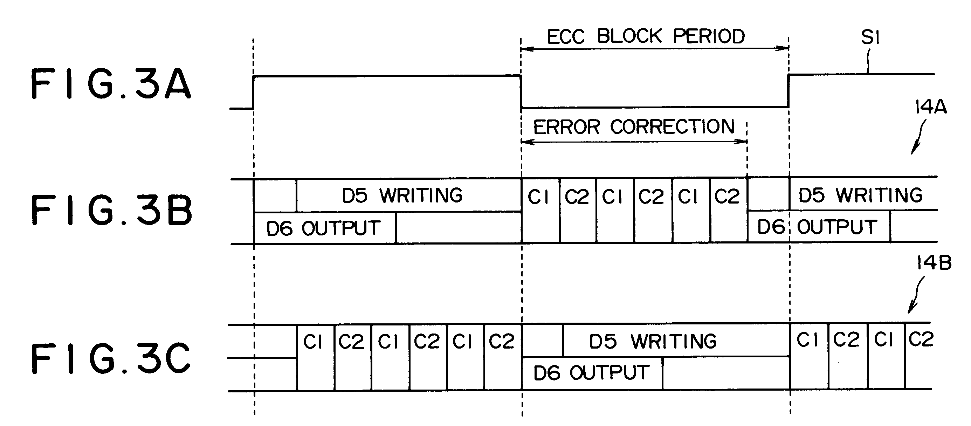

Fig. 1 is a block diagram for illustrating the memory 14 and ECC circuit 15 of the optical disc device. Herein, the memory 14 comprises a general-purpose memory with 8 bit width, and the internal memory area is divided into first and second memory areas 14A and 14B. Further, the memory 14 switches its operation in response to a control signal S1 (Fig. 3(A)) which changes in signal level synchronously with ECC block period as shown in Fig. 3, holds demodulation data D5 inputted from the demodulation circuit 13 synchronously with each ECC block period using alternately the two memory areas 14A and 14B, and performs error correction processing of the held demodulation data D5 (Fig. 3(B) and (C)). Thus, the memory 14 can ensure sufficient processing time for error correction processing of successive demodulation data D5.

In the error correction processing, the ECC circuit 15 repeats three times error correction processing using the C1 parity code (represented by code C1) and error correction processing using the C2 parity code (represented by code C2) respectively in order to ensure error correction of bit errors. Further, the ECC circuit 15 informs that the error is uncorrectable by way of outputting the correction processing result S2 to a system control circuit not shown in the drawing in the case that the error was uncorrectable in spite of such repeated error correction processing. In response to the uncorrectable information, the optical disc device 1 repeats retrial as required. In this embodiment, each ECC block is structured similarly to the ECC block described in Fig. 8.

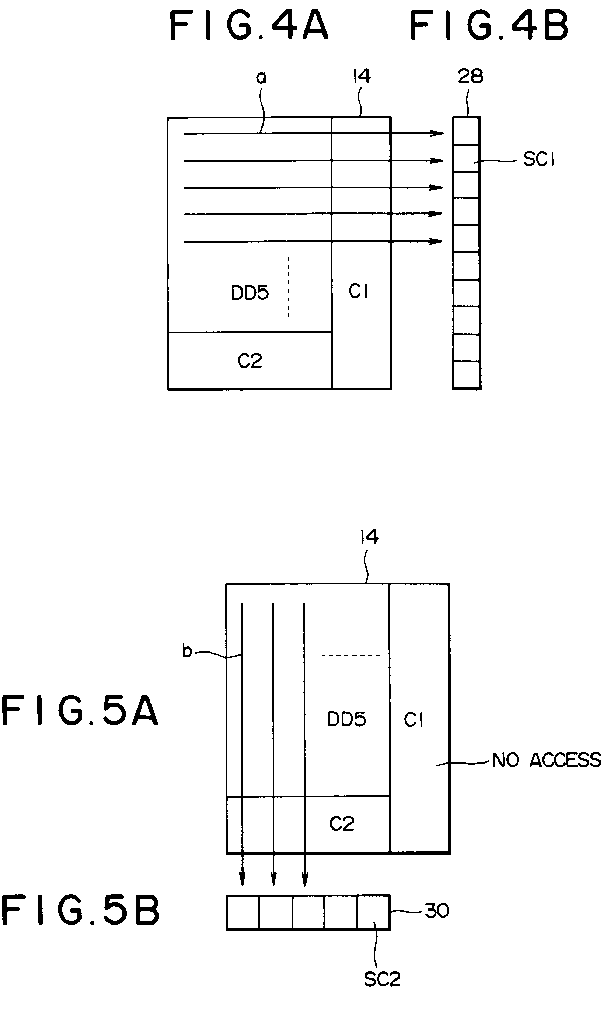

The memory 14 outputs the user data DD5, the C2 parity code C2, and the C1 parity code C1 during error correction processing using the C1 parity code so that the arrangement of the ECC block is scanned successively in the horizontal direction (so that scanned in frame unit) as shown with arrows-a in Fig. 4(A) correspondingly to the error correction processing and ECC block. After outputting of the user data DD5 as described herein above, the memory 14 rewrites the user data DD5 in compliance with control of the ECC circuit 15, and updates thereby the content using the correct user data DD5 which is subjected to error correction processing.

As shown in Fig. 5 with arrows-b, during error correction processing using the C2 parity code, the user data DD5 and the C2 parity code C2 are outputted so that the arrangement of the ECC block is scanned successively in the vertical direction. After outputting of the user data DD5 as described herein above, the user data DD5 is rewritten in compliance with control of the ECC circuit 15, and the user data DD5 is corrected thereby to a correct user data DD5 which was subjected to error correction processing, and thus the content is updated using this corrected user data DD5. During the error correction processing using the C2 parity code, the memory 14 does not output the C1 parity code in the vertical direction, and the ECC circuit 15 does not perform error correction processing in the vertical direction using the C1 parity code correspondingly to no output from the memory 14.

In the ECC circuit 15, an arithmetic circuit 25 switches operation in compliance with control of a controller not shown in the drawing, inputs successively the demodulation data D5 outputted from the memory 14 during error correction processing using the C1 parity code, and performs error detection for each frame as a unit. Further based on the error detection result, the demodulation data D5 subjected to error correction processing is stored in the memory 14 if it is a correctable error, and an error uncorrectable flag S3 is outputted if it is an uncorrectable error. Yet further, the arithmetic circuit 25 receives an input C2 eraser pointer SC2 through a selection circuit 27 during the error correction processing using the C1 parity code subsequent to error correction processing using the C2 parity code, and corrects the error with reference to the location of the bit error specified by the C2 eraser pointer SC2.

Thereby, the arithmetic circuit 25 operates error correction processing 208 times corresponding to 208 frames during error correction processing using the C1 parity code and outputs the process result for each error correction processing using an error uncorrectable flag S3.

Similarly, the arithmetic circuit 25 receives from the memory 14 an input of demodulation data D5 in the order of the vertical direction as described for Fig. 5 and detects an error in one row unit during an error correction processing using the C2 parity code. If the arithmetic circuit judges the error to be correctable based on the error correction result, the demodulation data D5 which was subjected to error correction processing is stored in the memory 14, otherwise, if the arithmetic circuit judges the data to be uncorrectable, the arithmetic circuit 25 outputs an error uncorrectable flag S3. Further the arithmetic circuit 25 receives an input of C1 eraser pointer SC1 through the selection circuit 27 during an error correction processing using the C2 parity code, and corrects the error with reference to the location of the bit error specified by the C1 eraser pointer SC1.

As described herein above, the arithmetic circuit 25 performs error correction processing 172 times corresponding to the number of user data of 1 frame during an error correction processing using the C2 parity code, and outputs each error correction processing result as an error uncorrectable flag S3.

For such error correction, the selection circuit 27 outputs C2 eraser pointer SC2 to be outputted from a C2 shift register 30 during error correction processing using the C1 parity code to the arithmetic circuit 25 with being controlled by a controller not shown in the drawing, on the other hand, outputs C1 eraser pointer SC1 to be outputted from a C1 shift register 28 to the arithmetic circuit 25 during error correction processing using the C2 parity code.

The C1 shift register 28 comprises a 206 bit shift register corresponding to the number of error correction processing using the C1 parity code, and inputs an error uncorrectable flag S3 through the selection circuit 29 during the error correction processing using the C1 parity code. Thereby the C1 shift register 28 fetches and holds successively C1 eraser pointers during error correction processing using the C1 parity code. Further the C1 shift register 25 performs bit shifting of the input content bit-by-bit correspondingly to the error correction processing using the C1 parity code when an error uncorrectable flag S3 is inputted. Thereby, the C1 shift register 28 can hold C1 eraser pointer SC1 corresponding to the frame which was subjected to error correction processing as shown in Fig. 4 with only a simple structure comprising the 208 bit shift register.

On the other hand, the shift register 28 performs bit-by-bit bit shifting of C1 eraser pointer SC1 which is to be held synchronously with the demodulation data D5 outputted from the memory 14 during error correction processing using the C2 parity code, and outputs it to the arithmetic circuit 25. Further the C1 shift register 28 inputs successively C1 eraser pointers to be fed back through the selection circuit 29 synchronously with the bit shifting.

In such operation described herein above, the selection circuit 29 inputs the error uncorrectable flag S3 outputted from the arithmetic circuit 25 to the C1 shift register 28 during error correction processing using the C1 parity code by way of controlling performed by a controller not shown in the drawing, and on the other hand, feeds back C1 eraser pointer SC1 outputted from the C1 shift register 28 to the C1 shift register 28 during error correction processing using the C2 parity code.

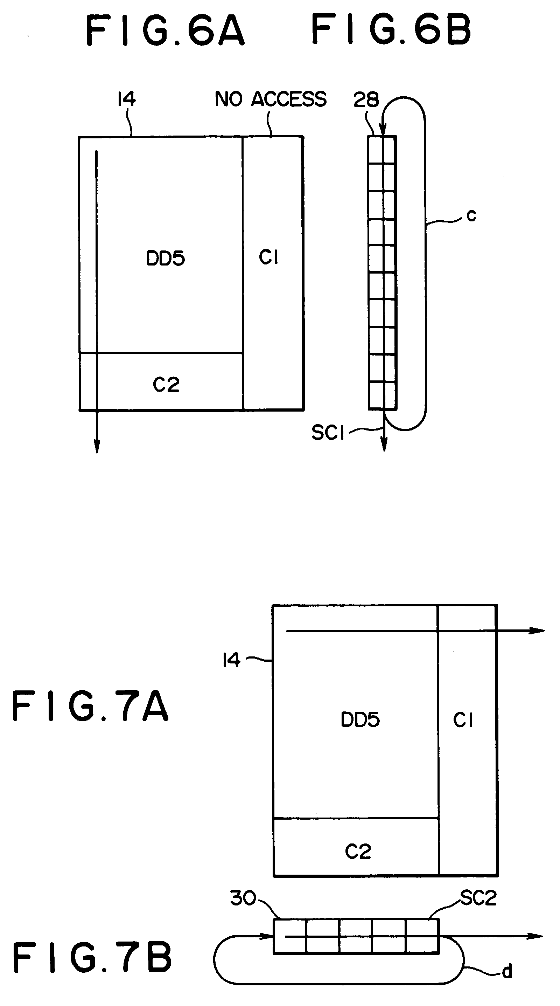

Thereby, the C1 shift register 28 circulates and holds successively C1 eraser pointer SC1 172 times that is the number of error correction processing in the arithmetic circuit 25 as shown in Fig. 6 with an arrow-c during error correction processing using the C2 parity code, and outputs C1 eraser pointer SC1 corresponding to the demodulation data D5 outputted from the memory 14 to the arithmetic circuit 25.

On the other hand, the C2 shift register 30 comprising a shift register having 172 bits corresponding to the number of error correction processing using the C2 parity code, and is controlled to be stopped in operation during the first C1 eraser correction. On the other hand, the C2 shift register 30 inputs an error uncorrectable flag S3 through the selection circuit 31 during error correction processing using the C2 parity code. Thereby the C2 shift register 30 fetches and holds successively the C2 eraser pointer SC2 during error correction processing using the C2 parity code. The C2 shift register 30 performs bit-by-bit bit shifting of the content inputted correspondingly to error correction processing using the C2 parity code when an error uncorrectable flag S3 is inputted. Thus the C2 shift register 30 holds C2 eraser pointer SC2 corresponding to each row which was subjected to error correction processing as shown in Fig. 5(B) with only simple structure comprising the shift register having 172 bits.

On the other hand, the C2 shift register 30 performs bit-by-bit bit shifting of C2 eraser pointer SC2 to be held synchronously with the demodulation data D5 outputted from the memory 14 during error correction processing using the C1 parity code subsequent to error correction processing using the C2 parity code, and outputs it to the arithmetic circuit 25 through the selection circuit 32.

In such operation described herein above, the selection circuit 31 inputs an error uncorrectable flag S3 outputted from the arithmetic circuit 25 to the C2 shift register 30 during error correction processing using the C2 parity code by way of controlling performed by a controller not shown in the drawing, on the other hand, feeds back C2 eraser pointer SC2 outputted from the C2 shift register 30 to the C2 shift register 30 during error correction processing using the C1 parity code subsequent to error correction processing using the C2 parity code.

Thereby the C2 shift register 30 circulates and holds successively the C2 eraser pointer SC2 208 times that is the number of error correction processing in the arithmetic circuit 25 as shown in Fig. 7 with an arrow-d during error correction processing using the C1 parity code subsequent to the error correction processing using the C2 parity code, and outputs C2 eraser pointer SC2 corresponding to the demodulation data D5 outputted from the memory 14 to the arithmetic circuit 25.

In this embodiment, the C1 parity code has no access during error correction processing using the C2 parity code. Correspondingly, the C2 shift register 30 stops the bit shift operation during error correction processing using the C1 parity code if the demodulation data D5 outputted from the memory 14 is the C1 parity code. Thereby the whole structure of the ECC circuit 15 can be miniaturized.

The selection circuit 32 is disposed between the C1 shift register 30 and arithmetic circuit 25, and outputs C2 eraser pointer SC2 outputted from the C2 shift register 30 to the arithmetic circuit 25. When, the selection circuit 32 switches the contact point to the earth side in response to the stop of operation of the C2 shift register 30, and sets the input terminal of C2 eraser pointer SC2 in the arithmetic circuit 25 to the logical level for the case of no bit error.

The ECC circuit 15 repeats error correction processing using the C1 parity code and the C2 parity code on the user data DD5 which is held in the memory 14, and stores the user data DD5 which was subjected to error correction processing as required in the memory 14, and the user data which was subjected to error correction processing is outputted to the subsequent ID decoder 16 as an output data D6.

An output register 34 inputs C2 eraser pointer SC2 having 172 bits held in the C2 shift register 30 at a time when the final error correction processing using the C2 parity code is completed after repeated error correction processing using the C1 parity code and the C2 parity code, and holds them. Further the output register 34 performs and outputs bit-by-bit successively the held C2 eraser pointer SC2 synchronously with output of demodulation data D6 from the memory 14, and feeds back the C2 eraser pointer which was outputted to the input side and holds it.

Thereby the ECC circuit 15 outputs the C2 eraser pointer SC2 as an error correction result S2, and herein outputting of the error correction processing result S2, performs simultaneously in parallel output of the error correction processing result S2 synchronous with the demodulation data D6 and error correction processing of the subsequent ECC block during the subsequent ECC block period by transmitting C2 eraser pointer SC2 from the C2 shift register 30 to the output register 34.

In the structure described herein above, a user data D1 (Fig. 2) inputted from the computer is inputted to the EDC encoder 6 through the buffer memory 5 in a predetermined block unit, and a code for error detection is added in this stage. Further the user data D1 is subjected to interleave processing in the scramble circuit 7, thereafter, added with a fixed data such as synchronizing signal by the ID encoder 8, and then stored in the memory 14. The data stored in the memory 14 is added with the C1 parity code and the C2 parity code for error correction by the ECC circuit 10, and the modulated data D2 is generated. The modulated data D2 is modulated to a modulation data D3 in the modulation data generation circuit 11, and the modulation data D3 drives the modulation coil 4. Thereby the user data D1 is recorded thermomagnetically in the magneto-optic disc 2.

The optical pick-up 3 irradiates a laser beam onto the magneto-optic disc 2 in which the user data D1 is recorded, and the plane of polarization of the reflected beam is detected, and the reproduction signal RF is generated. The reproduction signal RF is converted to a binary signal in the demodulation circuit 13, a reproduction clock is generated from the binary signal, and further the binary signal is latched successively with reference to the reproduction clock and a reproduction data is generated. Further the reproduction data is subjected to inverse recording processing to generates a demodulation data D5, the demodulation data D5 is stored in the memory 14, and receives error correction processing performed by the ECC circuit 15.

When, the demodulation data D5 is stored in the memory 14 with switching alternately between the first and second memory areas 14A and 14B of the memory 14 with the ECC block period (Fig. 3), stored in the memory 14, subjected to error correction processing performed by the ECC circuit 15, and outputted from the memory 14. Sufficient processing time for error correction processing is given to the demodulation data D5, and the error correction processing is performed consistently.

In the error correction processing herein in detail, the demodulation data D5 is subjected to the error correction processing using the C1 parity code and the error correction using the C2 parity code alternately three times respectively. In the first error correction processing that is an error correction processing using the C1 parity code, the user data DD5, the C1 parity code, and the C2 parity code of the demodulation data D5 are scanned successively in the horizontal direction in the arrangement described for Fig. 8, supplied from the memory 14 to the arithmetic circuit 25, subjected to error correction processing in each frame unit, and the content of the memory 14 is corrected with the correct user data DD5 which was subjected to error correction processing (Fig. 4).

In the case that the error is uncorrectable during the error correction processing using the C1 parity code, an error uncorrectable flag S3 outputted from the arithmetic circuit 25 rises, and the error uncorrectable flag S3 is inputted to the C1 shift register 28 through the selection circuit 29 and held in it. In the C1 shift register 28, the error uncorrectable flag S3 of the demodulation data DD5 is held successively correspondingly to the processing period of a frame in the arithmetic circuit 25, subjected to bit-by-bit bit shifting, and thereby error correction processing results of each frame are held in the C1 shift register 28 as C1 eraser pointer SC1.

When the first error correction processing using C1 parity is completed as described herein above, the demodulation data D5 is subjected to error correction processing using the C2 parity code. In this processing, the user data DD5 and the C2 parity code of the demodulation data D5 are scanned successively in the vertical direction in the arrangement described for Fig. 8, supplied from the memory 14 to the arithmetic circuit 25, subjected to error correction processing in each frame unit, and the content of the memory 14 is corrected with the correct user data DD5 which was subjected to error correction processing (Fig. 5).

When, C1 eraser pointer SC1 held in the C1 shift register 28 is subjected to bit-by-bit bit shifting synchronously with output from the memory 14 to the arithmetic circuit 25, and thus the demodulation data D5 is supplied to the arithmetic circuit 25, fed back to the C1 shift register 28 to be circulated to the C1 shift register 28, thereby the error correction processing result using the C1 parity code of the corresponding frame is supplied synchronously to the arithmetic circuit 25 (Fig. 6). Further in the arithmetic circuit 25, error correction processing is performed with reference to the frame having an bit error specified by the C1 eraser pointer SC1, thereby error correction capability is improved.

In the case that the error is uncorrectable during the error correction processing using the C2 parity code, an error uncorrectable flag S3 outputted from the arithmetic circuit 25 rises, and the error uncorrectable flag S3 is inputted to the C2 shift register 30 through the selection circuit 31 and held in it. In the C2 shift register 30, the error uncorrectable flag S3 of the demodulation data D5 (¥1) is held successively correspondingly to the error correction processing period of column unit in the arithmetic circuit 25, subjected to bit-by-bit bit shifting, and thereby error correction processing results of each frame are held in the C2 shift register 30 as C2 eraser pointer SC2.

When, only the user data DD5 and the C2 parity code of the demodulation data D5 are inputted to the arithmetic circuit 25, thereby the processing in the vertical direction corresponding to the C1 parity code is brought to a stop in the arithmetic circuit 25, and C2 eraser pointer SC2 is stored in the C2 shift register 30 in the vertical direction excepting the C1 parity code (Fig. 5).

When the first error correction processing using the C1 parity code and the error correction processing using the C2 parity code are completed as described herein above, the demodulation data D5 is subjected to error correction processing using the subsequent the C1 parity code. In the subsequent error correction processing using the C1 parity code, the demodulation data D5 is supplied from the memory 14 to the arithmetic circuit 25 as in the case of the first error correction processing using the C1 parity code, and the content of the memory 14 is updated. C1 eraser pointer SC1 that is an error correction processing result is held in the C1 shift register.

When, C2 eraser pointer SC2 held in the C2 shift register 30 is subjected to bit-by-bit bit shifting synchronously with output from the memory 14 to the arithmetic circuit 25, and thus the demodulation data D5 is supplied to the arithmetic circuit 25, fed back to the C2 shift register 30 to be circulated to the C2 shift register 30, thereby the error correction processing result using the C2 parity code of the corresponding column is supplied synchronously to the arithmetic circuit 25 (Fig. 7). Further in the arithmetic circuit 25, error correction processing is performed with reference to the column having an bit error specified by the C2 eraser pointer SC2, thereby error correction capability is improved.

Bit shifting operation of the demodulation data D5 on column in the vertical direction corresponding to the C1 parity code in the C2 shift register 30 is controlled to be stopped, the contact point of the selection circuit 32 is switched to the earth side contact point, and thus error correction processing is performed under the condition that is set to no bit error detection on the column in the vertical direction corresponding to the C1 parity code.

When the first error correction processing using the C1 parity code, the error correction processing using the C2 parity code, and the subsequent error correction using the C1 parity code are completed as described herein above, the demodulation data D5 is subjected further to the subsequent error correction processing using the C2 parity code and the yet subsequent error correction processing using the C1 parity code alternately and repeatedly, and stored in the memory 14. When the series of error correction processing is completed, the user data DD5 is outputted from the memory 14 to the ID decoder 16 in the predetermined order.

The demodulation data D5 is transmitted to the output register 34 with C2 eraser pointer SC2 held in the C2 shift register 30 at a time synchronously with the timing of the starting of output to the ID decoder 16. Thereby C2 shift register 30 becomes vacant in the ECC circuit 15, and is used for error correction processing of the subsequent ECC block. When being outputted from the memory 14, C2 eraser pointer SC2 transmitted to the output register 34 is subjected successively to bit shifting and the demodulation data D6 is outputted as an error correction processing result S2, and the user data which is judged to be error uncorrectable based on the error correction processing result S2 is subjected to repeated reproduction processing from the magneto-optic disc 2 as required.

The user data D6 outputted from the memory 14 as described herein above is subjected to processing corresponding to recording and outputted to an internal apparatus from the buffer memory 19.

According to the structure as described herein above, C1 eraser pointer SC1 and C2 eraser pointer SC2 are held in the C1 shift register and C2 shift register respectively, the held C1 eraser pointer SC1 and C2 eraser pointer SC2 are circulated corresponding to the arithmetic circuit 25 and supplied to the arithmetic circuit 25, and thereby the error correction processing can be performed with holding the demodulation data in the memory 14 having 8 bit width. Therefore the data of this sort can be subjected to error correction processing using a general-purpose memory.

The memory space is utilized more efficiently in comparison with the use of an exclusive use memory having 9 bit width. In the case that a memory having 9 bit width is used for the above-mentioned ECC block shown in Fig. 8, it requires additional memory space of 208 × (172+10) bits in comparison with the case that uses a memory of 8 bit width. On the other hand, in the embodiment described herein above, error correction processing can be performed by expanding the memory space of the shift registers of only 208 bits and 172 bits. The excessive memory space can be utilized usefully.

When the memory space of the memory 14 is divided and error correction processing and data input and output processing are performed simultaneously in parallel by outputting C2 eraser pointer SC2 synchronously with data output from the memory 14 after C2 eraser pointer SC2 is transmitted at a time to the output register, the C2 shift register is assigned to the subsequent error correction processing, and the error correction processing result can be outputted. Therefore, sufficient time is affordable with a simple structure for error correction processing in this embodiment.

In the embodiment described hereinbefore, the case that the error correction processing using the C1 parity code and the error correction code using the C2 parity code are repeated alternately three times respectively, however, the present invention is by no means limited to the case of three times, but the number of repetition can be select optionally as required, and for example, only C1 shift register may be disposed correspondingly to the selected number of repetition.

Further in the embodiment described hereinbefore, the case that user data recorded in a magneto-optic disc are reproduced is described, however the present invention is by no means limited to this case, but the present invention can be applied widely to various cases including the case that various data recorded in a phase-change type optical disc are reproduced, the case that various data are transmitted through a transmission line such as an optical disc, and the case that audio data or video data are subjected to error correction processing.

According to the present invention as described hereinbefore, eraser pointers are held in the register when error correction processing is performed using product code type error correction code repeatedly, and error correction processing can be thereby performed with using a general-purpose memory.

## Claims

1. An error correction method for correcting an error of a matrix data group disposed in the horizontal and vertical directions with a predetermined arrangement to which first and second error correction codes are added in said horizontal and vertical directions respectively, wherein error correction processing in the horizontal direction and then error correction processing in the vertical direction are performed successively, in said error correction processing in the horizontal direction,
error correction processing (25) is performed successively on said data group arranged in the horizontal direction using said first error correction code, said error correction result in the horizontal direction is held by first shift register (28) corresponding to said data group in the vertical direction,
in said error correction processing (25) in the vertical direction,
error correction processing is performed successively on said data group arranged in the vertical direction using said second error correction code, and
the error correction processing result held in said first shift register (28) is circulated successively in order to perform error correction processing with reference to the error correction result held in said first shift register (28).

2. The error correction method as claimed in claim 1, wherein:
subsequent error correction processing in the horizontal direction is performed subsequently to said error correction processing in the vertical direction,
in said error correction processing in the vertical direction,
said error correction result in the vertical direction is held in a second shift register (30) corresponding to said data group in the horizontal direction,
in said subsequent error correction processing (25) in the horizontal direction,
error correction processing is performed successively on said data group arranged in the horizontal direction using said first error correction code, and
the error correction processing result held in said second shift register (30) is circulated successively in order to perform error correction processing with reference to the error correction result held in said second shift register (30).

3. An error correction device comprising:
memory means (14) for holding a matrix data group disposed in the horizontal and vertical direction with a predetermined arrangement to which first and second error correction codes are added in said horizontal direction and vertical direction respectively with said first and second error correction codes, and for outputting at a predetermined timing,
arithmetic means (25) for performing error correction processing in the horizontal direction and error correction processing in the vertical direction, in said error correction processing in the horizontal direction, for performing error correction processing successively on said data group arranged in the horizontal direction using said first error correction code in order to output said error correction result in the horizontal direction, and in said error correction processing in the vertical direction,
for performing error correction processing successively on said data group arranged in the vertical direction using said second error correction code with reference to said error correction processing result in the horizontal direction, and
first shift register (28) for holding successively said error correction processing result in the horizontal direction in said error correction processing in the horizontal direction, and for circulating successively said held error correction processing result to output it to said arithmetic means (25) in said error correction processing in the vertical direction.

4. The error correction device as claimed in claim 3, wherein:
said arithmetic means (25) performs the subsequent error correction processing in the horizontal direction subsequently to said error correction processing in the vertical direction,
outputs the error correction processing result in the vertical direction in said error correction processing in the vertical direction, and
performs error correction processing successively on said data group arranged in the horizontal direction using said first error correction code with reference to said error correction result in the vertical direction in said subsequent error correction processing in the horizontal direction, and
said error correction device comprising a second shift register (30) holding successively said error correction processing result in the vertical direction in said error correction processing in the vertical direction, and circulates successively said held error correction processing result in said subsequent error correction processing in the horizontal direction in order to output it to said arithmetic means (25)

5. The error correction device as claimed in claim 4, wherein:
said memory (14) has the first and second memory areas, said first and second memory areas are assigned alternately to store said data group, and first and second error correction codes, thereafter, outputs them to said arithmetic means (25), and
outputs said data group on which error correction processing was performed completely, and
said error correction device
holds said error correction processing result held in said first (28) or second shift register (30) and has a third shift register (34) for outputting said error correction processing result synchronously with output of said data group.

6. The error correction device as claimed in claim 5, wherein:
said second shift register (30) holds successively said error correction processing result in the vertical direction correspondingly to the arrangement in the vertical direction of said data group, and circulates successively the held error correction processing result, and in the said error correction processing in the vertical direction corresponding to said first error correction code and corresponding said error correction processing in the horizontal direction comes to a stop in operation.
